# EUROPÄISCHE PATENTSCHRIFT

(11) **EP 0 530 603 B1**
(45) Veröffentlichungstag und Bekanntmachung des Hinweises auf die Patenterteilung: **07.01.1998**
(21) Anmeldenummer: 92114223.8
(22) Anmeldetag: 20.08.1992
(51) Int. Cl.: H05B 41/29

(54) **Schaltungsanordnung zum Betrieb einer Lampe**
Circuit for operating a lamp
Circuit pour alimenter une lampe

(30) Priorität: 04.09.1991 DE 4129430
(43) Veröffentlichungstag der Anmeldung: 10.03.1993
(73) Patentinhaber: Patent-Treuhand-Gesellschaft für elektrische Glühlampen mbH, 81543 München (DE)
(72) Erfinder: Roll, Ulrich, Dr., W-8900 Augsburg (DE); Bernhard, Werner, W-8900 Augsburg (DE); Reiser, Ludwig, W-8906 Gersthofen (DE)

(56) Entgegenhaltungen:
- EP-A- 0 062 276
- EP-A- 0 093 469
- EP-A- 0 221 864
- EP-A- 0 420 251
- DE-A- 3 943 272
- DE-A- 4 011 742

## Beschreibung

Die Erfindung betrifft eine Schaltungsanordnung zum hochfrequenten Betrieb einer Lampe, insbesondere einer Niederdruckentladungslampe, gemäß dem Oberbegriff des Anspruchs 1.

Bei solchen freischwingenden Schaltungen müssen die Schaltelemente mit einer Ansteuerleistung im Takt der Schaltfrequenz versorgt werden. Die bekannten Anordnungen benutzen hierzu einen separaten Stromwandler, der entweder als Sättigungsstromwandler oder als Übertrager mit definiertem Luftspalt ausgebildet ist. Dieser stellt ab einer bestimmten Spannungs-Zeit-Fläche über seiner Eingangswicklung keinen Steuerstrom bzw. keine Steuerspannung mehr für das bzw. die Schaltelemente zur Verfügung, so daß dessen bzw. deren Basis/Gate ausgeräumt und das bzw. die Schaltelemente dadurch abgeschaltet werden. Ein Beispiel für eine solche Schaltungsanordnung findet sich z.B. in dem Buch "Elektronikschaltungen" von W. Hirschmann (Siemens AG, 1982) auf den Seiten 148 und 150.

Nachteil bei einer solchen Schaltungsanordnung ist jedoch, daß für die Ansteuerung der Schaltelemente des Schaltnetzteils als Stromwandler bzw. Übertrager ein separates teures Wickelteil benötigt wird. Außerdem weisen die für die Wickelteile verwendeten Ferritkerne gewisse Fertigungstoleranzen auf, die bei Sättigungsstromwandlern einen ganz erheblichen Einfluß auf die Funktionsparameter haben.

Aufgabe der Erfindung ist es, eine Schaltungsanordnung der oben beschriebenen Art zu schaffen, bei der auf einen separaten Stromwandler in Form eines Sättigungsstromwandlers oder eines Übertragers verzichtet werden kann. Die Schaltungsanordnung sollte einen einfachen Aufbau besitzen und kostengünstig herstellbar sein.

Die Aufgabe wird durch die kennzeichnenden Merkmale des Anspruchs 1 gelöst. Weitere vorteilhafte Merkmale der Schaltungsanordnung sind den Unteransprüchen zu entnehmen.

Die Verwendung von spannungsgesteuerten elektronischen Schaltelementen in Form von MOSFET- oder IGBT-Transistoren und die Steuerung dieser Schaltelemente über eine zusätzliche Hilfswicklung auf der sowieso benötigten Resonanz- und Strombegrenzungsinduktivität bzw. -drossel in Verbindung mit einem Impulsformungs- und Phasenschiebernetzwerk aus RC-Tiefpässen macht einen separaten Stromwandler unnötig. Das Impulsformungs- und Phasenschiebernetzwerk besitzt keine eigene Polstelle, d.h. es bildet keine Eigenresonanzen. Die Steuerung des bzw. der Schaltelemente erfolgt durch die Schwingung des Lastkreises, dessen Eigenfrequenz durch die Resonanzinduktivität bzw. -drossel und die resultierende Resonanzkapazität gegeben ist. Der Ansteuerkreis ist dabei als einseitige Steuerstartschaltung in Form eines Monoflops ausgeführt.

Aus der EP-A-0 221 864 ist eine freischwingende Adapterschaltung bekannt, bei die Steuerung der bipolaren Transistoren durch eine zusätzliche Hilfswicklung auf der Resonanzinduktivität über ein RC-Glied erfolgt. Das RC-Glied dient hier zur Verringerung von kurzen Spannungsspitzen beim Umschalten der bipolaren Transistoren. Der Anlauf der Schaltung erfolgt durch Steuern der bipolaren Transistoren in den "Klasse A"-Bereich, wodurch ein kleiner Steuerstrom erzeugt wird, der dann mittels Rauschanlauf die Transistoren zum Anschwingen bringt.

Die EP-A-0 420 251 behandelt ein Halbbrücken-Schaltnetzteil, bei dem die Steuerung der bipolaren Transistoren aus einem separaten Steuertrafo über jeweils ein RC-Glied erfolgt. Bei der Halbbrückenschaltung in der DE-A-3 943 272 erfolgt die Steuerung der bipolaren Transistoren über ein RC-Glied und einen zwischengeschalteten Hilfstransistor aus einem separaten Hochfrequenztransformator. Beide Schaltungungsanordnungen werden durch Rauschanlauf gestartet.

Auch die Vorschaltanordnung der EP-A-0 062 276 beinhaltet eine Halbbrükkenschaltung mit bipolaren Transistoren, deren Steuerspannungen aus Hilfswicklungen der Resonanzdrossel gewonnen werden. Ein RC-Glied zur Phasenschiebung ist nicht vorgesehen. Die Ansteuerung der Vorschaltanordnung erfolgt über eine Steuerstartschaltung.

Der DC/AC Konverter aus der EP-A-0093469 weist in der Halbbrückenschaltung einen Monoflop zu Ansteuerung und ein RC-Glied zur Phasenschiebung auf. Das RC-Glied wirkt jedoch nicht auf den bipolaren Haupttransistor, sondern auf einen invertierend wirkenden bipolaren Hilfstransistor. Die Steuerspannung für die Transistoren wird aus einem separaten Steuertrafo gewonnen.

Als Schaltnetzteil können bei der vorliegenden Schaltungsanordnung alle freischwingenden Wandlertypen, wie z.B. Eintakt-, Gegentakt- oder auch symmetrische und asymmetrische Halbbrücken- und Vollbrückenschaltungen dienen.

Der bzw. die RC-Tiefpässe können auch variabel oder als aktiver Phasenschieber gestaltet sein, so daß zur Wendelvorheizung eine erhöhte Frequenz zur Verfügung steht. Außerdem können bei der Schaltung zur weiteren Impulsformung zusätzliche Bauelemente in Form von Widerständen, Dioden oder einem Varistor vorgesehen sein.

Mit Hilfe eines aktiven oder passiven Ausräumnetzwerks, z.B. in Form eines Hilfstransistors zwischen Phasenschieber und Schaltelement, kann ein beschleunigtes Abschalten des bzw. der Schaltelemente erreicht werden, wobei durch Schutzbauelemente in Form von z.B. Zenerdioden das Gate des bzw. der Schaltelemente geschützt werden.

Im Fall von Schaltnetzteilen mit einem integrierten Trenn- oder Spartransformator kann die Resonanzinduktivität auch über eine Streuinduktivität im Trafo integriert sein. Die Kopplung der Hilfswicklung erfolgt dann zur Sekundärseite des Trafos.

Die Erfindung ist anhand der nachfolgenden Figuren näher veranschaulicht.
- Figur 1: zeigt eine erfindungsgemäße Schaltungsanordnung mit einem Schaltnetzteil in Form einer Halbbrücke mit MOSFET-Transistoren
- Figur 2 und 3: zeigt verschiedene Ausführungen des erfindungsgemäßen Schaltungsteils für unterschiedliche Schaltnetzteile
- Figur 4 und 5: zeigt verschiedene Ausführungen des erfindungsgemäßen Schaltungsteils mit variablem Phasenschieber
- Figur 6: zeigt eine Ausführung des erfindungsgemäßen Schaltungsteils mit einem aktiven Phasenschieber
- Figur 7 und 8: zeigt verschiedene Ausführungen des erfindungsgemäßen Schaltungsteils mit einem zusätzlichen Impulsformungsnetzwerk
- Figur 9 und 10: zeigt verschiedene Ausführungen des erfindungsgemäßen Schaltungsteils mit einem zusätzlichen Ausräumnetzwerk für das bzw. die elektronischen Schaltelemente

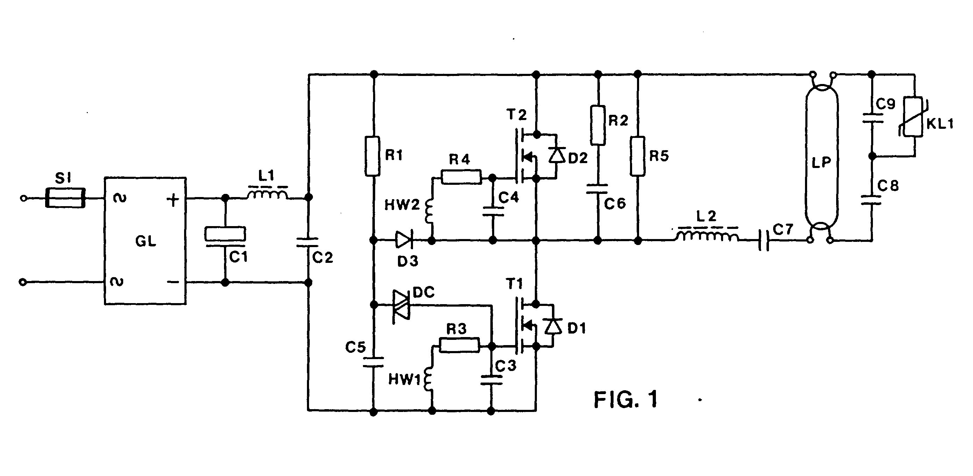

In Figur 1 ist das genaue Schaltbild einer Schaltungsanordnung mit einer Gegentakt-Halbbrücke zum Betrieb einer Kompaktleuchtstofflampe LP dargestellt. Direkt an den Netzeingang ist in eine Zuleitung eine Sicherung SI geschaltet. Anschließend folgt der Gleichrichter GL, dessen Ausgang durch einen Glättungskondensator C1 überbrückt ist, sowie ein Funkentstörungsglied aus einer Filterdrossel L1 in der positiven Zuleitung und einem Kondensator C2 parallel zum Glättungskondensator C1. Die selbststeuernde Gegentakt-Halbbrücke besteht aus den beiden MOSFET-Transistoren T1, T2 mit den Rückstromdioden D1, D2 und dem Ansteuerkreis mit den Widerständen R1, R5, dem Kondensator C5, der Diode D3 und dem Diac DC. Die Lampe LP ist mit einem Anschluß der ersten Elektrode über einen Koppelkondensator C7 und eine Resonanzinduktivität L2 mit dem Mittenabgriff zwischen den beiden Transistoren T1, T2 und mit einem Anschluß der zweiten Elektrode mit dem Pluspol des Gleichrichters GL verbunden. Außerdem ist ein Serienresonanzkreis aus der Resonanzinduktivität L2, dem Koppelkondensator C7 und zwei Resonanzkondensatoren C8, C9 vorgesehen, wobei die beiden Resonanzkondensatoren C8, C9 in Reihe in den Heizkreis der Lampe LP geschaltet sind. Parallel zum Resonanzkondensator C9 ist außerdem ein Kaltleiter KL1 gelegt. Parallel zur Schaltstrecke des Transistors T2 ist zusätzlich zur Entlastung der Schaltelemente eine Reihenschaltung aus einem Widerstand R2 und einem Kondensator C6 geschaltet.

Erfindungsgemäß erfolgt die Ansteuerung der Transistoren T1, T2 über Hilfswicklungen HW1, HW2, die auf der Resonanzinduktivität bzw. -drossel L2 angebracht sind. Zwischen die Hilfswicklungen HW1, HW2 und die Gate- bzw. Basiseingänge der MOSFET-Transistoren T1, T2 ist außerdem jeweils ein Impulsformungs- und Phasenschiebernetzwerk in Form eines RC-Tiefpasses mit den Widerständen R3 bzw. R4 und den Kondensatoren C3 bzw. C4 geschaltet.

Nach dem erstmaligen Anstoßen der Schaltung über den Diac DC schaltet der Transistor T1 durch und erhält daraufhin seine Ansteuerspannung über die entsprechend gepolte Hilfswicklung HW1 auf der Resonanzdrossel L2. Es fließt ein sinusförmig ansteigender Strom durch die Drossel L2 und die Anordnung aus den Kapazitäten C7 bis C9 mit eingekoppelter Lampe LP. Die Spannung über der Drossel L2 und damit auch über der Hilfswicklung HW1 nimmt nun gemäß u(t) = -L x di/dt ab und erreicht ihren Nulldurchgang im Sinus-Maximum des Drosselstroms.

Ist das Gate ohne Phasenverschiebung, d.h. ohne den RC-Tiefpaß R3, C3 mit der Hilfswicklung HW1 verbunden, unterschreitet die Ansteuerspannung des Transistors T1 kurz vor dem Sinus-Maximum des Drosselstroms die Schwellspannung und schaltet den Transistor T1 ab. Der in der Drossel L2 eingeprägte Strom kehrt nun bei ausgeschaltetem Transistor T1 die Spannung über der Drossel L2 um und fließt über die im Transistor T2 enthaltene Freilaufdiode D2 und die aus den Kondensatoren C7 bis C9 resultierende Kapazität parallel zum Verbraucher, bis die gespeicherte Energie aufgebraucht ist und er Null durchläuft. Beim Umpolen der Spannung über der Drossel L2 und damit auch über den Hilfswicklungen HW1 und HW2 wird der Transistor T1 durch die negative Gatespannung gesperrt und der Transistor T2 während des Betriebs der eigenen Freilaufdiode D2 aufgesteuert. Dadurch schwingt der Strom in der Drossel L2 nach dem Nulldurchgang weiter sinusförmig in den negativen Bereich (durch T2 positiv), bis kurz vor Sinusmaximum auch hier wieder die Ansteuerspannung über der Hilfswicklung HW2 die Gate-Schwellspannung des Transistors T2 unterschreitet und somit diesen Transistor T2 abschaltet. Die erneut umkehrende Spannung über der Drossel L2 und den Hilfswicklungen HW1 und HW2 steuert nun den Transistor T1 an, durch dessen eigene Freilaufdiode D1 der in der Drossel L2 eingeprägte Strom, wie oben beschrieben, weiterfließt. Anschließend beginnt der Vorgang wieder von vorn.

Mit der oben beschriebenen Schaltungsanordnung ohne die RC-Tiefpässe R3, C3 und R4, C4 stellt sich eine Betriebsfrequenz ein, die etwa dem doppelten der Eigenfrequenz des Resonanzkreises entspricht. Damit ist es aber nicht möglich, eine hohe Zündspannung zu generieren und/oder eine große Betriebsspannung (bezogen auf die Halbbrückenspannung) am Verbraucher anzubieten.

Wird nun jeweils ein RC-Tiefpaß R3, C3 bzw. R4, C4 zwischen die Hilfswicklung HW1 bzw. HW2 und den Gateeingang der Transistoren T1, T2 gelegt, so erreicht die Steuerspannung am Gate phasenverschoben die Ausschaltschwelle erst nach dem Maximum des Stroms der Resonanzdrossel L2. Die Steuerspannung schaltet dann den jeweiligen Transistor auch erst verzögert ein; dies stört jedoch nicht, da, wie oben beschrieben, der Strom am Anfang noch durch die jeweilige Freilaufdiode fließt. Zudem schützt das RC-Glied das Gate der Transistoren vor den von der Resonanzdrossel L2 erzeugten Spannungsspitzen während des Schaltvorgangs. Durch die Tiefpässe und die damit verbundene Phasenverschiebung wird die Betriebsfrequenz nach unten in Richtung Eigenfrequenz verschoben.

Es erfolgt eine wirksame Anregung der Eigenresonanz für die Zündung. Auch hochohmige Lasten können durch Resonanzüberhöhung betrieben werden.

Durch die Dimensionierung der RC-Tiefpässe kann der Abschaltzeitpunkt der Transistoren T1, T2 für den Zündbetrieb an einem ganz bestimmten Phasenwinkel des Drosselstroms festgelegt werden, so daß die Resonanzstelle für hohe Zündspannungswerte exakt getroffen wird. Auch bei großer Netzunterspannung, wie z.B. beim Dimmen mit kleinen Lampenströmen (hochohmige Lampe), ergibt sich ein sehr stabiler Betrieb durch die definierte Resonanzüberhöhung. Bei Normalbetrieb oder Netzüberspannung mit höheren Lampenströmen (niederohmige Lampe) bewirkt die Kompaktleuchtstofflampe LP parallel zu den Resonanzkondensatoren C8, C9 ein langsames Abklingen des Stroms in der Resonanzdrossel L2. Dies führt zu einer starken Bedämpfung der Resonanzüberhöhung (geringere Gesamtgüte) und zu einer effektiven Verschiebung der Eigenfrequenz nach unten. Es ergibt sich eine Leistungsvariation, die unterproportional zur Spannungsvariation ist.

In der nachfolgenden Tabelle sind die verwendeten Schaltelemente für eine Schaltungsanordnung gemäß Figur 1 zum Betreiben einer Kompaktleuchtstofflampe mit einer Leistungsaufnahme von 20 W an einem 120 V-Wechselstromnetz zusammengestellt:

| | |
|---|---|
| SI | 1,6 A, M |
| GL | B 250 C 800 DM |
| C1 | 47 µF, 200 V |
| L1 | 150 µH |
| C2, C7 | 220 nF, 250 V |
| R1, R5 | 220 kΩ |
| C5 | 0,1 µF |
| R3, R4 | 1 kΩ |
| C3, C4 | 6,8 nF |
| T1, T2 (mit D1, D2) | BSS 297 |
| D3 | 1 N 4004 |
| DC | NEC N 413 M |
| R2 | 22 Ω |
| C6 | 1 nF |
| L2 | 1,2 mH; 200,5 Windungen Kern EF 16 |
| HW1, HW2 | 20 Windungen |
| C8 | 15 nF, 400 V |
| C9 | 10 nF, 400 V |
| KL1 | Siemens S 1380 P 120 |

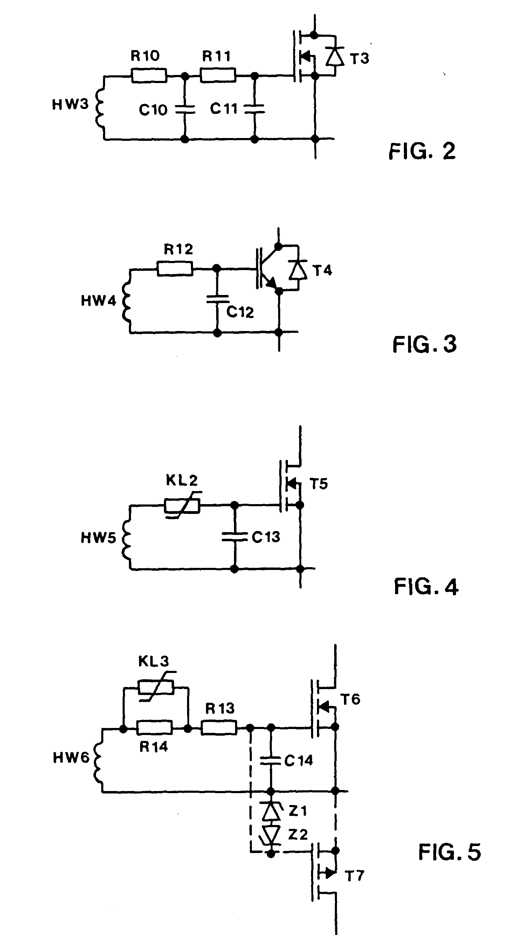

In Figur 2 ist ein weiteres erfindungsgemäßes Schaltungsteil für die Schaltungsanordnung dargestellt, bei dem zwischen den MOSFET-Transistor T3 und die Hilfswicklung HW3 zwei RC-Tiefpässe R10, C10 und R11, C11 in Reihe geschaltet sind. Mit diesem Schaltungsteil lassen sich Phasenverschiebungen zwischen der Steuerspannung für die Transistoren und dem Maximum des Drosselstromes von 90° (im Gegensatz zu kleiner 90° bei nur einem Tiefpaß) erzielen, sofern dies zur Erreichung der Eigenresonanz der Schaltungsanordnung erforderlich ist.

Figur 3 zeigt das erfindungsgemäße Schaltungsteil für ein Schaltnetzteil mit einem oder mehreren spannungsgesteuerten IGBT-Transistoren T4. Auch hier besteht das Impulsformungs- und Phasenschiebernetzwerk aus einem RC-Tiefpaß R12, C12 in Reihe zwischen der Hilfswicklung HW4 und dem IGBT-Transistor T4.

In den Figuren 4 und 5 finden sich Beispiele für ein Impuls- und Phasenschiebernetzwerk, bei dem der Phasenschieber variabel gestaltet ist.

Bei dem Schaltungsteil in Figur 4 besteht das Impuls- und Phasenschiebernetzwerk aus einem RC-Tiefpaß, wobei als Widerstand ein Kaltleiter KL2 verwendet wird, der neben dem Kondensator C13 zwischen die Hilfswicklung HW5 und den MOSFET-Transistor T5 geschaltet ist.

Bei dem Schaltungsteil in Figur 5 ist zusätzlich vor den RC-Tiefpaß aus dem Widerstand R13 und dem Kondensator C14 eine Parallelschaltung eines Kaltleiters KL3 und eines Widerstands R 14 zwischen die Hilfswicklung HW6 und den Widerstand R13 geschaltet. Sofern die Schaltungsanordnung als Schaltelemente eine Halbbrücke aufweist, kann beim zweiten MOSFET-Transistor T7 auf eine eigene Ansteuerung mit Impuls- und Phasenschiebernetzwerk verzichtet werden. Der MOSFET-Transistor T7 muß dann ein P-Kanal-Transistor (im Gegensatz zum N-Kanal-Transistor T6) sein, wobei die Gates der beiden Transistoren T6, T7 direkt miteinander verbunden sind. Ein Schutz der Gates vor Überspannungen während des Zündens der Lampe wird durch zwei gegeneinandergeschaltete Zenerdioden Z1, Z2 ermöglicht.

Durch den veränderlichen Widerstand des Kaltleiters KL2 bzw. KL3 arbeitet die jeweilige Schaltungsanordnung zur Wendelvorheizung mit einer erhöhten Frequenz ohne Resonanzanregung, wobei die Frequenz bei Erwärmung des Kaltleiters in die Betriebsfrequenz übergeht.

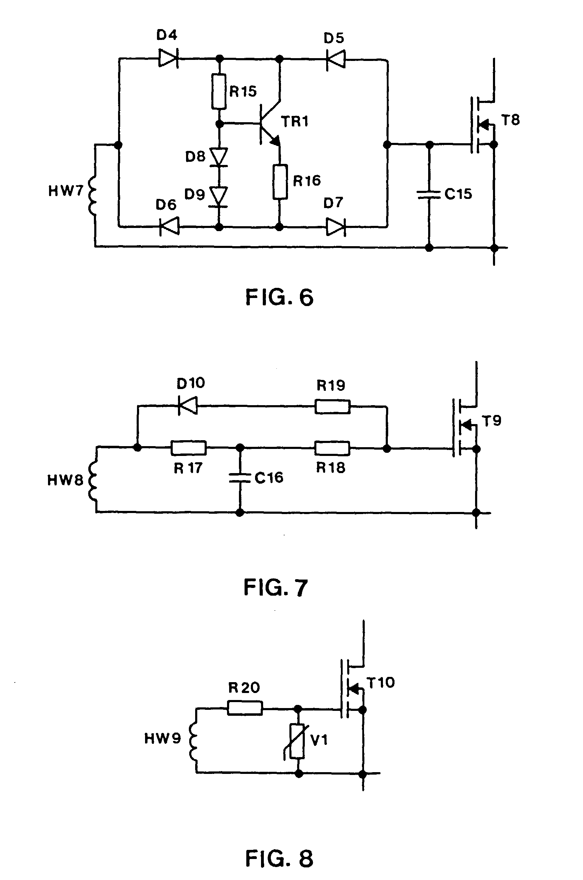

Figur 6 zeigt ein Impuls- und Phasenschiebernetzwerk für das erfindungsgemäße Schaltungsteil mit einem aktiven Phasenschieber. Der Widerstand des RC-Tiefpasses ist hierbei als Stromquelle konzipiert und besteht aus den Brückengleichrichterdioden D4 bis D7, dem NPN-Transistor TR1, den Vorwiderständen R15, R16 und den Stromquellendioden D8, D9. Die Stromquelle ist entsprechend dem Widerstand im RC-Tiefpaß für den MOSFET-Transistor T8 zwischen die Hilfswicklung HW7 und den Kondensator C15 geschaltet. Die Stromquelle kann auch als integrierter Schaltungsbaustein ausgeführt sein.

Figur 7 und 8 zeigt erfindungsgemäße Schaltungsteile mit zusätzlichen Impulsformungseinheiten für das Impuls- und Phasenschiebernetzwerk.

Figur 7 zeigt einen RC-Tiefpaß, bestehend aus dem Widerstand R17 und dem Kondensator C16 als Netzwerk zwischen der Hilfswicklung HW8 und dem MOSFET-Transistor T9, wobei zwischen den Verbindungspunkt des Widerstands R17 mit dem Kondensator C16 und den Gate-Eingang des Transistors T9 ein weiterer Widerstand R18 geschaltet ist. Außerdem sind parallel zu den beiden Widerständen R17, R18 eine Diode D10 in Gleichstromsperrichtung und ein Widerstand R19 geschaltet. Ein solchermaßen verbessertes Impulsnetzwerk bringt eine Erhöhung der Totzeit des Schalttransistors T9 und ein verbessertes Abschaltverhalten. Figur 8 zeigt einen RC-Tiefpaß aus einem Widerstand R20 und einem Varistor V1 zwischen der Hilfswicklung HW9 und dem Gate-Eingang des MOSFET-Transistors T10. Die parasitäre Kapazität des als Gateschutz eingebauten Varistors kann hierbei als Phasenschieber-Kondensator genutzt werden.

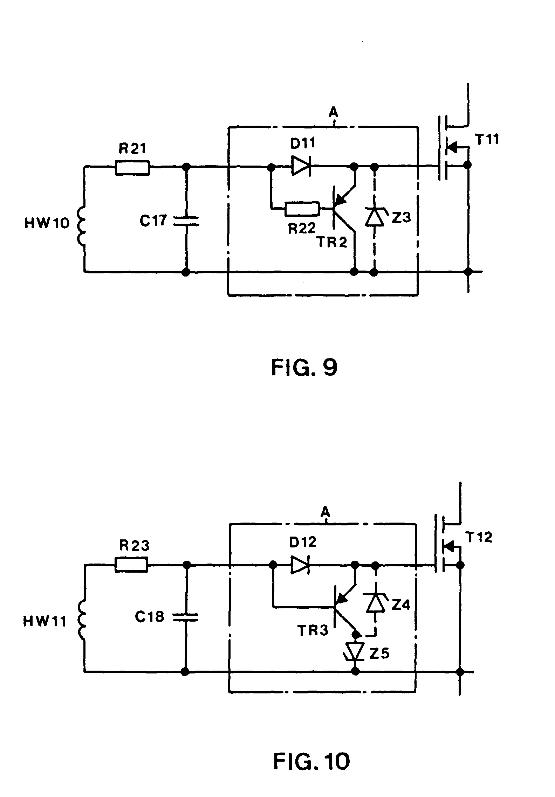

In Figur 9 und 10 sind erfindungsgemäße Schaltungsteile mit einem zusätzlichen aktiven Ausräumnetzwerk A dargestellt. Das Ausräumnetzwerk A besteht dabei aus einem PNP-Transistor TR2 bzw. TR3, der mit seiner Kollektor-Emitter-Strecke parallel zum Kondensator C17 bzw. C18 des aus dem Widerstand R21 bzw. R23 und dem Kondensator C17 bzw. C18 bestehenden RC-Tiefpaß für den MOSFET-Transistor T11 bzw. T12 geschaltet ist. Der Gate-Eingang des Transistors TR2 bzw. TR3 ist jeweils mit dem Verbindungspunkt des Widerstands R21 bzw. R23 und des Kondensators C17 bzw. C18 verbunden und zwischen diesen Verbindungspunkt und den Emittereingang des Transistors TR2 bzw. TR3 ist eine Diode D11 bzw. D12 geschaltet. Durch den Transistor TR2 bzw. TR3 wird ein schnelles Abschalten des MOSFET-Transistors T11 bzw. T12 erreicht. Das Ausräumnetzwerk beinhaltet außerdem einen zusätzlichen Gateschutz in Form von Zenerdioden. Die Zenerdioden Z3 - Z5 können dabei parallel zur Kollektor-Emitter-Strecke des Ausräumtransistors TR2 bzw. TR3 (s. Fig. 9) und evtl. zusätzlich zwischen den Kollektor des Ausräumtransistors T3 und das Referenzpotential (s. Fig. 10) geschaltet sein.

## Patentansprüche

1. Schaltungsanordnung zum hochfrequenten Betrieb einer Lampe, insbesondere einer Niederdruckentladungslampe (LP), wobei die Schaltungsanordnung folgende Merkmale aufweist:
- einen Netzgleichrichter (GL) mit Siebung (C1)
- ein selbststeuerndes Schaltnetzteil mit mindestens einem spannungsgesteuerten elektronischen Schaltelement (T1 - T12) und einem Ansteuerkreis
- einen Resonanzkreis, bestehend aus zumindest einer Resonanzinduktivität (L2) und einer Resonanzkapazität (C8, C9)
wobei die Steuerung des Schaltnetzteils durch eine zusätzliche Hilfswicklung (HW1 - HW11) auf der Resonanzinduktivität (L2) über einen ein- oder mehrstufigen RC-Tiefpass (R3, C3, R4, C4; R10, C10, R11, C11; R12, C12) erfolgt und der bzw. die RC-Tiefpässe (R3, C3, R4, C4; R10, C10, R11, C11; R12, C12) in Reihe zu der Hilfswicklung und den Gate-Eingang des mindestens einen spannungsgesteuerten elektronischen Schaltelements (T1 - T12) geschaltet sind,
dadurch gekennzeichnet, daß
- das mindestens eine spannungsgesteuerte elektronische Schaltelement (T1 - T12) ein MOSFET- oder IGBT-Transistor ist
- der Ansteuerkreis als einseitige Steuerstartschaltung in Form eines Monoflops ausgeführt ist und
- der bzw. die RC-Tiefpässe (R3, C3, R4, C4; R10, C10, R11, C11; R12, C12) ein bezogen auf die Halbperiodendauer der Schwingung wirksames Phasenschiebernetzwerk bilden, um die Schaltfrequenz des mindestens einen spannungsgesteuerten elektronischen Schaltelements (T1 - T12) an die Polstelle des Resonanzkreises (L2, C8, C9) anzunähern und somit eine wirksame Anregung dieses Resonanzkreises zu erreichen.

2. Schaltungsanordnung nach Anspruch 1, dadurch gekennzeichnet, daß der bzw. die RC-Tiefpässe variabel ausgestaltet sind.

3. Schaltungsanordnung nach Anspruch 1 und 2, dadurch gekennzeichnet, daß der Widerstand des bzw. der RC-Tiefpässe ein PTC-Widerstand (KL2, KL3) ist.

4. Schaltungsanordnung nach einem oder mehreren der Ansprüche 1 bis 3, dadurch gekennzeichnet, daß in Reihe zu einem ersten Widerstand (R13) im RC-Tiefpaß zwischen die Hilfswicklung (HW6) und den ersten Widerstand (R13) eine Parallelschaltung eines zweiten ohmschen Widerstands (R14) und des PTC-Widerstands (KL3) geschaltet ist.

5. Schaltungsanordnung nach Anspruch 1 und 2, dadurch gekennzeichnet, daß der Widerstand des bzw. der RC-Tiefpässe als Stromquelle (TR1, D4-D9, R16) ausgeführt ist.

6. Schaltungsanordnung nach Anspruch 1, dadurch gekennzeichnet, daß zur weiteren Impulsformung zwischen den bzw. die RC-Tiefpässe (R17, C16) und den Gate-Eingang des elektrischen Schaltelements (T9) ein dritter Widerstand (R18) geschaltet ist und parallel zu diesem dritten Widerstand (R18) und den in Reihe liegenden vierten Widerstand(R17) des bzw. der RC-Tiefpässe (R17, C16) eine Reihenschaltung aus einer Diode (D10) und einem fünften Widerstand (R19) geschaltet ist.

7. Schaltungsanordnung nach Anspruch 1 bis 3, dadurch gekennzeichnet, daß zur weiteren Impulsformung als Kondensator in den bzw. die RC-Tiefpässe (R20, V1) ein Varistor (V1) eingesetzt ist.

8. Schaltungsanordnung nach Anspruch 1, dadurch gekennzeichnet, daß zusätzlich ein aktives oder passives Ausräumnetzwerk (A) zum beschleunigten Abschalten des bzw. der elektronischen Schaltelemente (T11, T12) vorgesehen ist.

9. Schaltungsanordnung nach Anspruch 8, dadurch gekennzeichnet, daß das Ausräumnetzwerk (A) aus einem Transistor (TR2, TR3) besteht, der mit seiner Kollektor-Emitter-Strecke parallel zum Kondensator (C17, C18) des bzw. der RC-Tiefpässe (R21, C17; R23, C18) zwischen diesen Kondensator (C17, C18) und den Gate-Eingang des elektronischen Schaltelements (T11, T12) geschaltet ist.

10. Schaltungsanordnung nach Anspruch 1, dadurch gekennzeichnet, daß das Gate des elektronischen Schaltelements (T6, T7; T11, T12) durch Schutzbauelemente vor Überspannungen geschützt ist.

11. Schaltungsanordnung nach Anspruch 10, dadurch gekennzeichnet, daß die Schutzbauelemente Zenerdioden (Z1 - Z5) sind.

## Claims

1. Circuit arrangement for the high-frequency operation of a lamp, in particular of a low-pressure discharge lamp (LP), the circuit arrangement having the following features:
- a mains-power-supply rectifier (GL) with filtering (C1)
- a self-controlling switched-mode power supply having at least one voltage-controlled electronic switching element (T1 - T12) and a drive circuit
- a resonant circuit comprising at least one resonance inductor (L2) and a resonance capacitor (C8, C9)
the switched-mode power supply being controlled by an additional auxiliary winding (HW1 - HW11) on the resonance inductor (L2) by means of a single- or multistage RC low-pass filter (R3, C3, R4, C4; R10, C10, R11, C11; R12, C12) and the RC low-pass filter or filters (R3, C3, R4, C4; R10, C10, R11, C11; R12, C12) being connected in series with the auxiliary winding and the gate input of the at least one voltage-controlled electronic switching element (T1 - T12),
characterized in that
- the at least one voltage-controlled electronic switching element (T1 - T12) is a MOSFET or IGBT transistor
- the drive circuit is designed as a single-ended control start circuit in the form of a monostable multivibrator and
- the RC low-pass filter or filters (R3, C3, R4, C4; R10, C10, R11, C11; R12, C12) form a phase shifter network which is active with reference to the half-period duration of the oscillation in order to approximate the switching frequency of the at least one voltage-controlled electronic switching element (T1 - T12) to the pole point of the resonant circuit (L2, C8, C9) and thus achieve effective excitation of this resonant circuit.

2. Circuit arrangement according to Claim 1, characterized in that the RC low-pass filter or filters are of variable configuration.

3. Circuit arrangement according to Claims 1 and 2, characterized in that the resistor of the RC low-pass filter or filters is a PTC thermistor (KL2, KL3).

4. Circuit arrangement according to one or more of Claims 1 to 3, characterized in that a parallel circuit formed by a second non-reactive resistor (R14) and the PTC thermistor (KL3) is connected in series with a first resistor (R13) in the RC low-pass filter between the auxiliary winding (HW6) and the first resistor (R13).

5. Circuit arrangement according to Claims 1 and 2, characterized in that the resistor of the RC low-pass filter or filters is designed as a current source (TR1, D4-D9, R16).

6. Circuit arrangement according to Claim 1, characterized in that, for the purpose of further pulse shaping, a third resistor (R18) is connected between the RC low-pass filter or filters (R17, C16) and the gate input of the electrical switching element (T9), and a series circuit formed by a diode (D10) and a fifth resistor (R19) is connected in parallel with this third resistor (R18) and the series-connected fourth resistor (R17) of the RC low-pass filter or filters (R17, C16).

7. Circuit arrangement according to Claims 1 to 3, characterized in that, for the purpose of further pulse shaping, a varistor (V1) is inserted into the RC low-pass filter or filters (R20, V1) as capacitor.

8. Circuit arrangement according to Claim 1, characterized in that an active or passive depletion network (A) for the accelerated turning-off of the electronic switching element or elements (T11, T12) is additionally provided.

9. Circuit arrangement according to Claim 8, characterized in that the depletion network (A) comprises a transistor (TR2, TR3) which is connected by its collector-emitter path in parallel with the capacitor (C17, C18) of the RC low-pass filter or filters (R21, C17; R23, C18) between this capacitor (C17, C18) and the gate input of the electronic switching element (T11, T12).

10. Circuit arrangement according to Claim 1, characterized in that the gate of the electronic switching element (T6, T7; T11, T12) is protected against overvoltages by means of protective components.

11. Circuit arrangement according to Claim 10, characterized in that the protective components are zener diodes (Z1 - Z5).

## Revendications

1. Montage pour faire fonctionner en haute fréquence une lampe, notamment une lampe (LP) à décharge à basse pression, le montage ayant les caractéristiques suivantes:
- un redresseur (GL) de réseau avec lissage (C1)
- une alimentation à découpage indépendante comportant au moins un élément de commutation électronique commandé par tension (T1 à T12) et un circuit de commande,
- un circuit de résonance constitué d'au moins une inductance (L2) de résonance et d'une capacité (C8,C9) de résonance,
la commande de l'alimentation à découpage s'effectuant par un enroulement auxiliaire supplémentaire (HW1 à HW11) sur l'inductance (L2) de résonance par l'intermédiaire d'un passe-bas RC à un ou à plusieurs étages (R3, C3, R4, C4; R10, C10, R11, C11; R12, C12) et le ou les passe-bas RC (R3, C3, R4, C4; R10, C10, R11, C11; R12, C12) sont branchés en série avec l'enroulement auxiliaire et l'entrée de grille du au moins un élément (T1 à T12) de commutation électronique commandé par tension,
caractérisé en ce que
- le au moins un élément (T1 à T12) électronique de commutation commandé par tension est un transistor MOSFET ou IGBT
- le circuit de commande est réalisé sous forme de circuit de démarrage de commande d'un côté sous forme d'une bascule monostable et
- le ou les passe-bas RC (R3, C3, R4, C4; R10, C10, R11, C11; R12, C12) forment un réseau de déphasage actif rapporté à la durée d'une demi-période de l'oscillation, pour rapprocher la fréquence de commutation du au moins un élément (T1 à T12) de commutation électronique commandé par tension du pôle du circuit de résonance (L2, C8, C9) et ainsi obtenir une excitation efficace de ce circuit de résonance.

2. Montage suivant la revendication 1, caractérisé en ce que le ou les passe-bas est ou sont variables.

3. Montage suivant les revendications 1 et 2, caractérisé en ce que la résistance du ou des passe-bas RC est une résistance (KL2, KL3) à coefficient de température positif.

4. Montage suivant l'une ou plusieurs des revendications 1 à 3, caractérisé en ce qu'un circuit en parallèle d'une seconde résistance ohmique (R14) et de la résistance (KL3) à coefficient de température positif est branché en série avec une première résistance (R13) dans le passe-bas RC entre l'enroulement auxiliaire (HW6) et la première résistance (R13).

5. Montage suivant les revendications 1 et 2, caractérisé en ce que la résistance du ou des passe-bas RC est réalisée en tant que source de courant (TR1, D4 à D9, R16).

6. Montage suivant la revendication 1, caractérisé en ce qu'une troisième résistance (R18) est branchée pour former davantage des impulsions entre le ou les passe-bas RC (R17,C16) et l'entrée de grille de l'élément (T9) électrique de commutation et un circuit série constitué d'une diode (D10) et d'une cinquième résistance (R19) est branché en parallèle avec cette troisième résistance (R18) et la quatrième résistance (R17) se trouvant en série du ou des passe-bas (R17,C16).

7. Montage suivant l'une des revendications 1 à 3, caractérisé en ce qu'un varistor (V1) est inséré, pour former davantage des impulsions en tant que condensateur dans le ou les passe-bas (R20,V1).

8. Montage suivant la revendication 1, caractérisé en ce qu'il est prévu en supplément un réseau (A) actif ou passif d'extraction pour couper de manière accélérée le ou les éléments électroniques de commutation (T11 ,T12).

9. Montage suivant la revendication 8, caractérisé en ce que le réseau (A) d'extraction est constitué d'un transistor (TR2,TR3), qui est branché par sa voie collecteur-émetteur en parallèle avec le condensateur (C17,C18) du ou des passe-bas RC (R21,C17;R23,C18) entre ce condensateur (C17, C18) et l'entrée de grille de l'élément électronique (T11,T12) de commutation.

10. Montage suivant la revendication 1, caractérisé en ce que la grille de l'élément électronique de commutation (T6,T7;T11,T12) est protégée des surtensions par des composants de protection.

11. Montage suivant la revendication 10, caractérisé en ce que les composants de protection sont des diodes Zener (Z1 à Z5).
